# DEMANDE DE BREVET EUROPEEN

(11) **EP 4 047 642 A1**
(43) Date de publication de la demande: **24.08.2022**
(21) Numéro de dépôt: 22167250.4
(22) Date de dépôt: 20.12.2010
(51) Int. Cl.: H01L 21/762

(54) **SUBSTRAT HYBRIDE A ISOLATION AMELIOREE**

(30) Priorité: 22.12.2009 FR 0906233
(62) Demande divisionnaire de: 10354093.6
(71) Demandeur: Commissariat à l'Energie Atomique et aux Energies Alternatives, 75015 Paris (FR); STMicroelectronics Crolles 2 SAS, 38920 Crolles (FR)
(72) Inventeur: Fenouillet-Beranger, Claire, 38500 Voiron (FR); Denorme, Stéphane, 38920 Crolles (FR); Coronel, Philippe, 38530 Barraux (FR)
(74) Mandataire: Talbot, Alexandre

(57) **Abrégé**

Un substrat hybride comporte des première (1) et seconde (3) zones actives en matériaux semi-conducteur décalées latéralement et séparées par une zone d'isolation (5). Les surfaces principales de la zone d'isolation (5) et de la première zone active (1) forment un plan. Le substrat hybride est obtenu à partir d'un substrat souche comportant successivement des couches en premier (2) et second (4) matériaux semi-conducteurs séparées par une couche d'isolation (6). Un unique masque de gravure est utilisé pour structurer la zone d'isolation (5), la première zone active (1) et la seconde zone active (3). La surface principale de la première zone active (1) est libérée formant ainsi des zones vides dans le substrat souche. Le masque de gravure est éliminé au-dessus de la première zone active (1). Un premier matériau d'isolation est déposé, aplani et gravé jusqu'à libérer la surface principale de la première zone active (1).

## Description

### Domaine technique de l'invention

L'invention est relative à un substrat hybride comportant :
- une première zone active en premier matériau semi-conducteur,
- une seconde zone active en second matériau semi-conducteur,
- les première et seconde zones actives étant disposées, latéralement, de part et d'autre d'une zone d'isolation en premier matériau d'isolation,
- les premier et second matériaux semi-conducteurs étant séparés par une couche d'isolation en second matériau d'isolation dans une direction perpendiculaire à une surface principale d'une couche de support.

### État de la technique

L'utilisation de transistors à effet de champ formés sur des substrats de type silicium sur isolant présente de nombreux avantages, notamment, une simplification du dessin des circuits intégrés et une amélioration des performances des dispositifs. De plus, afin de satisfaire à des contraintes toujours plus importantes, les substrats utilisés présentent des épaisseurs de silicium et d'oxyde enterré de plus en plus fines.

Cependant, l'utilisation d'un transistor intégré sur un film mince présente également de nombreux inconvénients. Les dispositifs à effet de champ sont, par exemple, inadaptés à l'utilisation de courants importants que l'on retrouve typiquement dans les modules d'entrée/sortie. Il est également difficile d'intégrer un transistor bipolaire sur un substrat de type semi-conducteur sur isolant mince ce qui limite les possibilités offertes quant aux dispositifs utilisables dans les circuits intégrés.

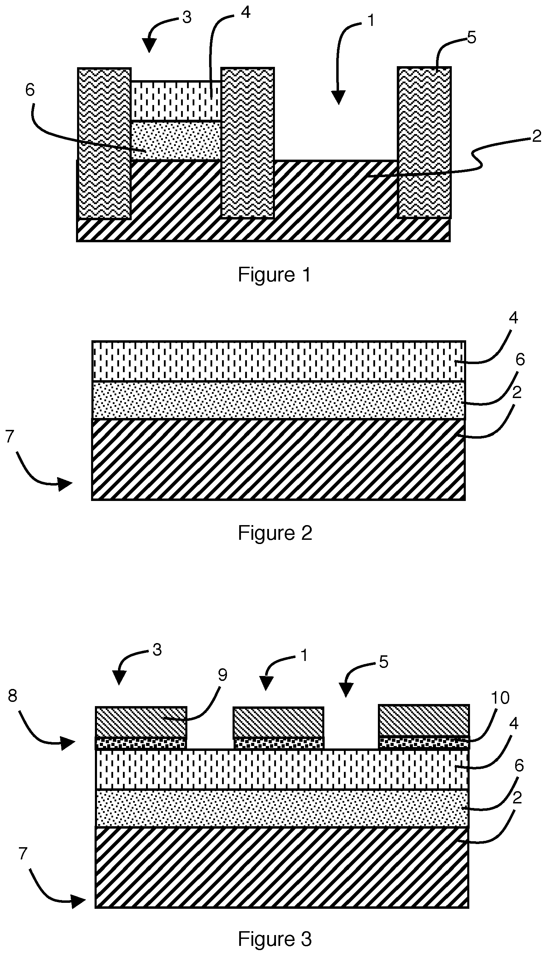

Afin de s'autoriser une plus grande largesse dans la conception des circuits intégrés, des substrats hybrides sont utilisés. Comme illustré à la figure 1, ces substrats hybrides comportent une première zone active 1 en premier matériau semi-conducteur 2, typiquement une zone de semi-conducteur sur isolant et une seconde zone active 3 en second matériau semi-conducteur 4 qui est de type substrat massif. Les première 1 et seconde 3 zones actives sont séparées latéralement par une zone d'isolation 5.

Comme illustré à la figure 2, ces substrats hybrides sont réalisés à partir d'un substrat souche de type semi-conducteur sur isolant qui est transformé afin de présenter les deux types de zones actives 1, 3. Le substrat souche comporte une couche d'isolation 6 qui est disposée entre les premier et second matériaux semi-conducteur. Ces deux types de zones actives sont alors utilisées pour former des dispositifs différents. Une manière conventionnelle de réaliser un tel substrat hybride est de graver le second matériau semi-conducteur 4 et la couche d'isolation 6 pour atteindre le premier matériau semi-conducteur 2, une fois que les zones d'isolation sont réalisées. Ainsi, le substrat de silicium est mis à nu et forme la première zone active 1. La zone d'isolation 5 s'enfonce dans le substrat en silicium 2 et est plus haute que la couche de silicium sur isolant de la seconde zone active 3. La première zone active 1 est donc encaissée entre les différentes zones d'isolation 5.

Afin de ne libérer que les zones actives choisies, le procédé de réalisation d'un substrat hybride est compliqué à mettre en oeuvre. Il nécessite l'alignement d'une étape de photolithographie et de gravure par rapport aux différentes zones actives présente. Un désalignement de l'étape de protection des secondes actives 3 entraîne l'obtention de motifs parasites dans la première 1 et/ou la seconde 3 zones actives et une élimination au moins partielle d'un des motifs d'isolation 5 bordant les première 1 et/ou seconde 3 zones actives. Il apparaît donc que le procédé de réalisation limite fortement les possibilités d'intégration de la structure d'un point de vue industriel.

Le substrat obtenu n'est pas non plus optimal car il est moins pratique à utiliser que les substrats conventionnels et les circuits obtenus n'ont pas une durée de vie et un rendement de fabrication aussi bon que les circuits réalisés sur les substrats conventionnels.

### Objet de l'invention

L'invention a pour objet un substrat qui est particulièrement intéressant pour la réalisation de circuits intégrés à fort rendement de fabrication.

On tend à obtenir un tel résultat au moyen d'un substrat selon la revendication 1 et plus particulièrement un substrat dans lequel la zone d'isolation comporte une première portion bordant au moins un bord latéral de la première zone active, la première portion et la première zone active ayant une face principale libre formant un même plan avec l'interface entre la couche en premier matériau semi-conducteur et la couche d'isolation, la zone d'isolation et la première zone active ayant des formes complémentaires le long d'une interface entre la zone d'isolation et la première zone active.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en coupe, un substrat hybride selon l'art antérieur,
- la figure 2 représente, de manière schématique, en coupe, un substrat selon l'art antérieur,
- les figures 3, 4, 5, 19 et 20 représentent, de manière schématique, en coupe et en vue de dessus, les étapes d'un procédé de réalisation d'un substrat hybride, selon l'invention,
- les figures 6 à 10 représentent de manière schématique, en coupe, différentes variantes d'un premier mode de réalisation du procédé selon l'invention,
- les figures 11 à 18 représentent de manière schématique, en coupe, différentes variantes d'un second mode de réalisation du procédé selon l'invention.

### Description d'un mode de réalisation préférentiel de l'invention

Comme illustré à la figure 2, le substrat de départ est un substrat souche qui comporte au moins une couche en premier matériau semi-conducteur 2, une couche en second matériau semi-conducteur 4 et une couche d'isolation 6. Le substrat souche comporte également une couche de support 7.

La couche en premier matériau semi-conducteur 2 peut être formée à la surface de la couche de support 7 ou être formée par une zone surfacique de la couche de support 7, c'est-à-dire dans la couche de support 7 (figure 2). La couche en premier matériau semi-conducteur 2 peut également être de type semi-conducteur sur isolant, par exemple de type partiellement déplété. Elle est alors séparée de la couche de support 7 par un matériau diélectrique dit diélectrique enterré (non représenté). De ce fait, le premier matériau semi-conducteur 2 peut être dans le même matériau que la couche de support 7 ou alors dans un matériau différent. Il est également envisageable que la couche de support 7 et le premier matériau semi-conducteur 2 présentent la même orientation cristallographique ou des orientations différentes.

La couche en second matériau semi-conducteur 4 est séparée de la couche en premier matériau semi-conducteur 2 par au moins une couche d'isolation 6. Le second matériau semi-conducteur 4 est donc de type semi-conducteur sur isolant. Le second matériau semi-conducteur 4 est séparé de la couche de support 7 au moins par la couche d'isolation 6 si le premier matériau semi-conducteur 2 est réalisé directement à la surface de la couche de support 7. Les premier 2 et second 4 matériaux semi-conducteurs peuvent être dans des matériaux identiques ou différents et présenter des orientations identiques ou différentes.

Ainsi, dans une vue en coupe et quel que soit l'empilement utilisé, le substrat souche comporte au moins successivement la couche de support 7, la couche en premier matériau semi-conducteur 2, la couche d'isolation 6 et la couche en second matériau semi-conducteur 4. Le substrat souche peut également comporter des couches additionnelles en matériaux semi-conducteurs et des couches d'isolation additionnelles. Cependant, quel que soit le mode de réalisation, la couche en premier matériau semi-conducteur 2 est disposée entre la couche de support 7 et la couche d'isolation 6. De même, la couche d'isolation 6 est disposée entre les premier 2 et second 4 matériaux semi-conducteurs. Le substrat source peut donc être de type semi-conducteur sur isolant.

Le substrat hybride devant être utilisé pour réaliser des circuits intégrés, il est avantageux de limiter au maximum la différence de hauteur entre la surface principale de la première zone active 1 en premier matériau semi-conducteur 2 et la surface principale de la seconde zone active 3 en second matériau semi-conducteur 4. La surface principale des zones actives est la surface sur laquelle est formée un transistor ou un dispositif électronique en général. Plus cette différence de hauteur est importante et plus il est difficile de réaliser des étapes de photolithographies de bonne qualité à cause des limitations de profondeur de champ des équipements utilisés.

Comme illustré à la figure 3, un masque de gravure 8 est formé sur le substrat souche, c'est-à-dire sur la couche la plus éloignée de la couche de support 7, ici le second matériau semi-conducteur 4. A titre d'exemple, le masque de gravure est formé dans un masque dur en premier matériau de protection 9. Dans une variante de réalisation, le masque de gravure 8 comporte au moins un premier matériau de protection 9 qui recouvre un matériau de protection additionnel 10. Selon les modes de réalisation le premier matériau de protection 9 et le matériau de protection additionnel 10 peuvent présenter des structurations différentes et donc des dessins différents.

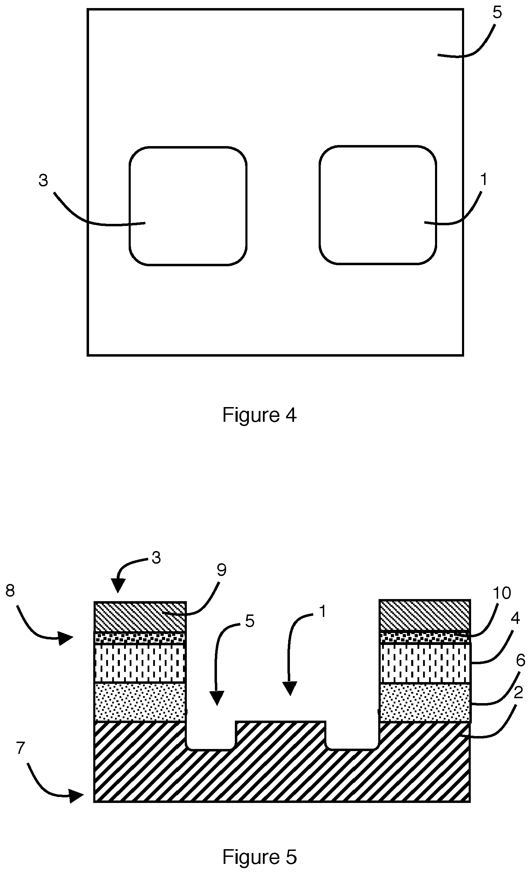

Le masque dur est structuré afin de former le masque de gravure 8. Le masque de gravure 8 délimite au moins une première zone active 1 du substrat, une seconde zone active 3 du substrat et une zone d'isolation 5 du substrat. Le masque de gravure peut délimiter une pluralité de premières zones actives 1, de secondes zones actives 3 et de zones d'isolation 5. Les première 1 et seconde 3 zones actives et la zone d'isolation 5 étant formées dans le masque de gravure, elles sont obligatoirement décalées latéralement les unes par rapport aux autres. Une zone d'isolation 5 sépare les première 1 et seconde 3 zones actives. En d'autres termes, dans un circuit intégré, la première zone active 1 et la seconde zone active 3 sont entourées par une zone d'isolation 5 comme illustré en vue de dessus à la figure 4. Dans le masque de gravure 8, la délimitation de la zone d'isolation 5 est définie par une zone vide alors que la délimitation des première 1 et seconde 3 zones actives est réalisée par une zone pleine. Cependant, il est envisageable de réalisée un masque de gravure de polarité inverse et de modifier cette polarité au fur et à mesure des étapes du procédé.

Le masque de gravure 8 comporte donc des dessins distincts délimitant les premières zones actives 1, des dessins délimitant les secondes zones actives 3 et des dessins délimitant les zones d'isolation 5. Ces trois types de dessins représentent l'intégralité de la surface du masque de gravure 5 (figure 4).

Comme illustré à la figure 5, une fois le masque de gravure 8 réalisé, la couche en premier matériau semi-conducteur 2, la couche en second matériau semi-conducteur 4 et la couche d'isolation 6 sont structurées pour délimiter la zone d'isolation 5 dans le premier matériau semi-conducteur 2 et libérer la surface principale de la première zone active 1 en premier matériau semi-conducteur 2. La surface principale de la première zone active 1 devant être libérée, il est nécessaire d'éliminer au-dessus du premier matériau semi-conducteur 2, la couche d'isolation 6, le second matériau semi-conducteur 4 et le masque de gravure 8 dans la zone indiquée. La structuration du premier matériau semi-conducteur 2 délimite simultanément la première zone active 1 et la zone d'isolation 5. La surface principale de la première zone active correspond à la surface du substrat de support qui réalisait l'interface avec la couche d'isolation. De cette manière, la surface principale de la première zone active est sous le niveau de la couche d'isolation 6. La surface principale de la première zone active est ici dans le même plan que l'interface entre le premier matériau semi-conducteur et la couche d'isolation 6.

Lors de cette structuration, la première zone active 1, la zone d'isolation 5 et la seconde zone active 3 sont délimitées. Il y a également structuration du masque de gravure 8 pour éliminer la portion du masque de gravure 8 qui délimite la première zone active 1. Cependant, cette structuration du masque de gravure 8 peut intervenir à différents moments selon les modes de réalisation utilisés.

De manière classique, pour atteindre le premier matériau semi-conducteur 2, la couche en second matériau semi-conducteur 4 et la couche d'isolation 6 sont structurées. Cette structuration peut être réalisée classiquement au moyen d'une gravure par plasma et elle peut s'enfoncer après le premier matériau semi-conducteur 2, par exemple jusque dans la couche de support 7.

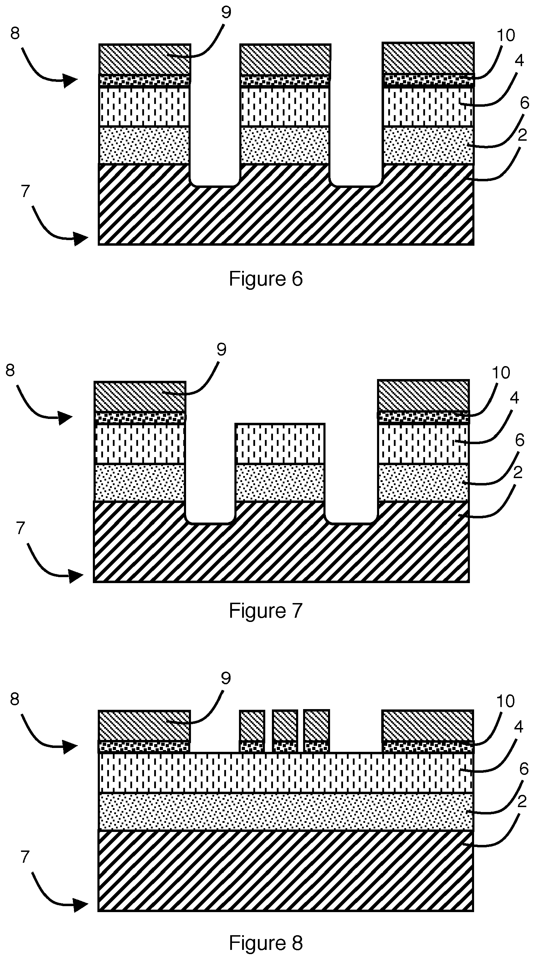

Dans un premier mode de réalisation, illustré à la figure 6, la zone libre du masque de gravure 8 délimite la zone d'isolation 5. Le second matériau semi-conducteur 4, la couche d'isolation 6 puis le premier matériau semi-conducteur 2 sont structurés successivement à partir du dessin représenté par la zone libre du masque de gravure 8. Le dessin de la zone d'isolation 5 est donc gravé dans les différentes couches se situant entre le masque de gravure 8 et la couche en premier matériau semi-conducteur 2. Cette structuration forme une zone vide dans le second matériau semi-conducteur 4, la couche d'isolation 6 et le premier matériau semi-conducteur 2. Cette structuration délimite également la seconde zone active 3 en second matériau semi-conducteur 4 au moment de la gravure de ce second matériau semi-conducteur 4.

Comme illustré à la figure 7, le masque de gravure 8 est ensuite structuré pour être éliminé au niveau de la première zone active 1. L'élimination de la portion du masque de gravure 8 qui délimite la première zone active 1 peut être réalisée par toute technique adaptée, par exemple au moyen d'une étape de photolithographie et de gravure. La surface principale de la première zone active est ensuite libérée en éliminant le second matériau semi-conducteur 4 et la couche d'isolation 6 se trouvant juste au-dessus de la première zone active. Le masque de gravure 8 peut être avantageusement utilisé pour protéger le reste du substrat lors de la gravure.

Dans une variante de réalisation avantageuse, illustrée à la figure 8, le dessin délimitant la première zone active 1 dans le masque de gravure 8 est réalisé au moyen d'une pluralité de motifs espacés les uns des autres. Ainsi, dans le masque de gravure 8, la délimitation de la première zone active 1 est réalisée par une alternance de motifs et de zones vides. La distance entre deux bords latéraux en regard de deux motifs adjacents est inférieure à la plus petite distance qui existe entre un bord latéral d'un dessin délimitant la première zone active 1 et un bord latéral d'un dessin délimitant la seconde zone active 3. En d'autres termes, la plus grande distance entre deux motifs adjacents est inférieure à la plus petite distance qui sépare la paroi latérale du dessin délimitant la première zone active de la paroi latérale du dessin de la seconde zone active 3. De plus, la dimension latérale et/ou longitudinale des motifs est inférieure à l'épaisseur du masque de gravure. A titre d'exemple, les motifs sont espacés d'environ le tiers de la distance qui sépare normalement deux transistors. Dans une intégration pour le noeud technologique 45nm, la distance minimale qui sépare deux transistors est de l'ordre de 100nm et de ce fait, la distance qui sépare deux motifs est de l'ordre de 30nm. Pour une intégration dans des noeuds technologiques inférieurs, il suffit de diminuer les distances précisées plus haut.

De ce fait, les motifs peuvent être de forme quelconque, par exemple, ils peuvent être carrés ou rectangulaires ou les deux. La paroi latérale du dessin délimitant la première zone active est obtenue en reliant tous les motifs se situant sur les bords. Leur taille peut être quelconque tant que la distance entre les motifs est respectée.

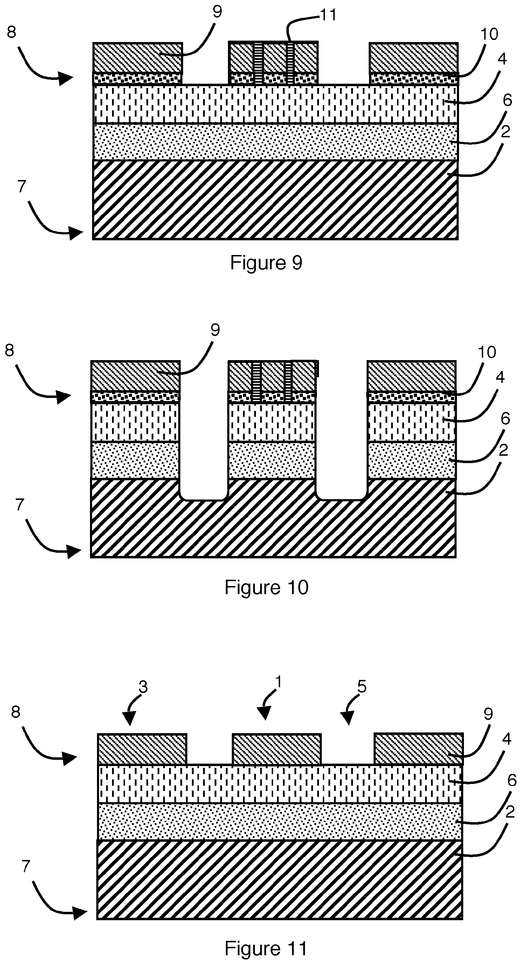

Comme illustré à la figure 9, un premier bouchon 11 est formé dans les espaces entre les motifs du dessin délimitant la première zone active afin de former un dessin plein, c'est-à-dire sans zone vide. Avantageusement, le premier bouchon 11 est formé au moyen d'un matériau de recouvrement déposé de manière conforme, c'est-à-dire qui épouse la forme du matériau qu'il recouvre. L'espace entre les motifs étant plus petit que l'espace entre la première zone active 1 et la seconde zone active 3, le matériau de recouvrement rebouche les zones vides du dessin de la première zone active 1 sans complètement reboucher le dessin délimitant la zone d'isolation, également une zone vide. L'épaisseur du matériau de recouvrement est choisie en conséquence et le matériau de recouvrement est ensuite éliminé de manière isotrope. De cette manière, le matériau de recouvrement n'est présent que dans le dessin délimitant la première zone active 1. La zone vide du masque de gravure 8 ne délimite plus que la zone d'isolation 5.

La structuration du second matériau semi-conducteur 4, de la couche d'isolation 6 et du premier matériau semi-conducteur 2 peut ensuite être réalisée. Une fois la structuration effectuée, le matériau de recouvrement est éliminé sélectivement par tout procédé adapté et les motifs délimitant la première zone active 1 sont éliminés. Cette élimination est avantageusement réalisée au moyen d'une gravure isotrope du ou des matériaux constituant le masque de gravure 8. Il y a alors un léger retrait du masque de gravure 8 au niveau des parois latérales des dessins des première 1 et seconde 3 zones actives.

Dans le cas où le masque de gravure 8 au-dessus de la première zone active 1 comporte un matériau de protection additionnel 10, l'élimination des motifs du dessin délimitant la première zone active 1 est réalisée au moyen de la gravure sélective du matériau de protection additionnel 10. Cette gravure sélective entraîne un décollement des motifs. Il est envisageable que le matériau de recouvrement et le matériau de protection additionnel 10 soit les mêmes ou qu'ils présentent une réactivité au même procédé de gravure.

Comme illustré à la figure 10, une fois le dessin du masque de gravure 8 délimitant la première zone active 1 éliminé, les parties du second matériau semi-conducteur 2 et de la couche d'isolation 6 délimitant la première zone active 1 sont également éliminées. Ainsi, une fois la zone d'isolation 5 définie dans le premier matériau semi-conducteur 2, tous les matériaux qui se trouvent au-dessus de la première zone active 1 en premier matériau semi-conducteur 2 sont enlevés, y compris le masque de gravure 8 pour libérer la surface principale de la première zone active 1.

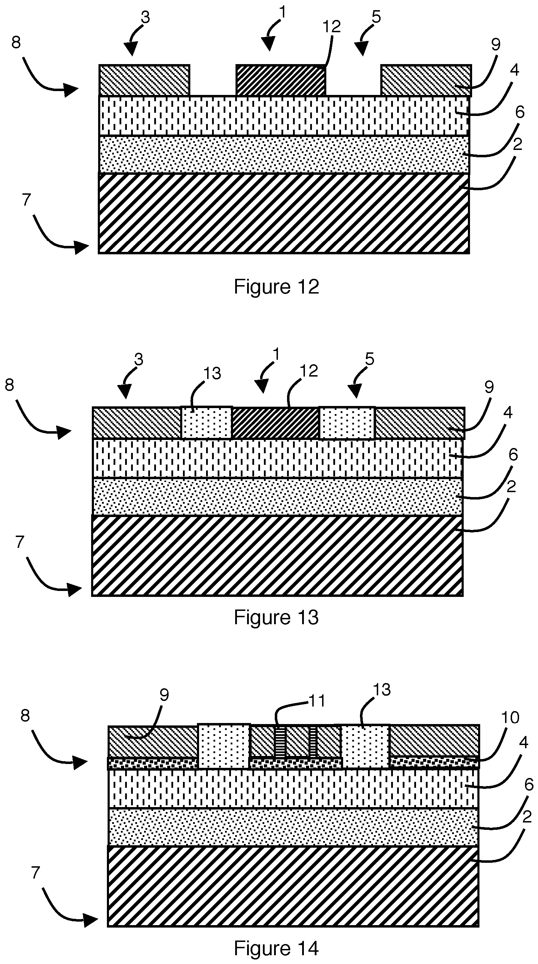

Dans une variante de réalisation illustrée aux figures 11 et 12, le premier matériau de protection 9 est remplacé par un second matériau de protection 12 uniquement dans le dessin délimitant la première zone active 1. Ce second matériau de protection 12 présente une sélectivité de gravure par rapport au premier matériau de protection 9. Le second matériau de protection 12 peut être formé par toute technique adaptée, par exemple, par l'implantation d'un dopant ou d'un autre matériau dans le premier matériau de protection 9 au niveau de la zone à transformer.

Dans une autre variante de réalisation illustrée à la figure 13, un second bouchon 13 est formé dans le masque de gravure 8 au niveau du dessin délimitant la zone d'isolation 5. Le second bouchon 13 délimite alors la zone d'isolation dans le masque de gravure 8. Après élimination du premier matériau de protection au niveau du dessin délimitant la première zone active, le second matériau de protection 12 est formé dans la zone vide du masque de gravure 8.

Dans encore une autre variante de réalisation, le masque de gravure comporte le premier matériau de protection 9 formé sur le matériau de protection additionnel 10. Le second matériau de protection 12 est alors formé par le matériau de protection additionnel 10 après élimination du premier matériau de protection 9. Avantageusement, le second bouchon est utilisé afin d'éviter la gravure latérale des dessins délimitant les première 1 et seconde 3 zones actives.

Dans tous ces modes de réalisation, le masque de gravure 8 délimite alors la première zone active 1, la seconde zone active 3 et la zone d'isolation 5 au moyen de trois matériaux différents qui peuvent présenter entre eux des différences d'épaisseur.

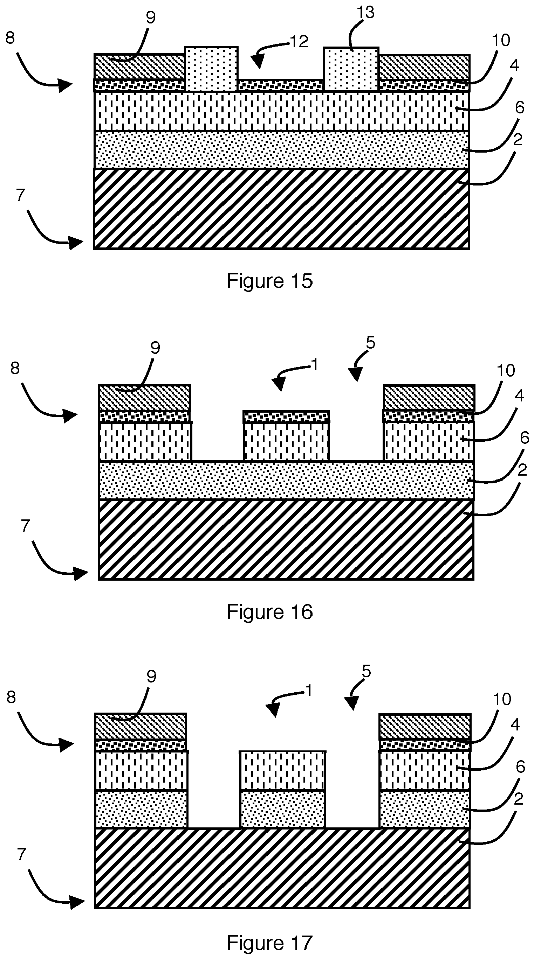

Comme dans un mode de réalisation précédent, le dessin du masque de gravure 8 délimitant la première zone active 1 peut être constitué par une pluralité de motifs espacés les uns des autres et qui présentent les mêmes contraintes dimensionnelles que précédemment. Le premier bouchon 11 est alors formé avant la formation du second matériau de protection 12. Dans une variante de réalisation avantageuse illustrée aux figures 14 et 15, le masque de gravure 8 comporte un premier matériau de protection 9 déposé au-dessus d'un matériau de protection additionnel 10. Le premier bouchon 11 est formé avant le second bouchon 13. La couche de protection additionnelle 10 est structurée une fois que le premier bouchon est formé. Le premier bouchon 11 est éliminé et le premier matériau de protection est éliminé au niveau du dessin de la première zone active au moyen d'une gravure anisotrope. De cette manière, l'épaisseur du premier matériau de protection 9 est légèrement diminuée dans le masque de gravure 8 et le dessin de la première zone active en premier matériau de protection 9 est éliminé (figure 15). Le second bouchon 13 est alors éliminé et le substrat est sensiblement identique à celui de la figure 12, l'épaisseur du masque de gravure 8 au-dessus de la zone active étant plus faible.

Comme illustré à la figure 13, une fois le second matériau de protection formé, le second bouchon 13 est éliminé et la zone d'isolation 5 est structurée dans le premier matériau semi-conducteur. Les couches situées au-dessus de la première zone active en premier matériau semi-conducteur sont enlevés.

Dans un mode de réalisation avantageux illustré aux figures 16 à 18, le second matériau de protection 12 est dans le même matériau que la couche d'isolation 6 ou dans un matériau qui se grave avec le même procédé de gravure. De cette manière, le masque de gravure 8 en premier 9 et second 12 matériaux de protection est utilisé pour structurer le second matériau semi-conducteur 4 et délimiter la zone d'isolation 5 et la seconde zone active 3 dans le second matériau semi-conducteur 4. La couche d'isolation 6 est ensuite structurée pour délimiter la zone d'isolation 5. La couche d'isolation 6 et le second matériau de protection 12 étant réactifs au même procédé de gravure, le second matériau de protection 12 est éliminé au niveau de la première zone active 1. Le premier matériau semi-conducteur 2 est ensuite structuré pour délimiter la zone d'isolation 5 et donc la première zone active 1 au moyen du motif en couche d'isolation 6 délimitant la première zone active 1. Le motif en couche d'isolation 6 est ensuite éliminé.

Dans ce mode de réalisation, les structurations sont réalisées au moyen de gravures anisotropes qui reproduisent dans la couche inférieure le dessin de la première zone active 1 provenant du masque de gravure 8.

Dans tous ces modes de réalisation, la structuration de la couche d'isolation 6 et des couches en premier matériau semi-conducteur 2, en second matériau semi-conducteur 4 et la libération de la surface principale de la première zone active 1 forme des zones vides dans le substrat souche. Ces zones vides sont localisées dans le second matériau semi-conducteur 4, dans la couche d'isolation 6 et dans le premier matériau semi-conducteur 2. Les zones vides sont également présentes dans le masque de gravure 8.

Dans le masque de gravure 8, dans le second matériau semi-conducteur 4 et dans la couche d'isolation 6, les zones vides correspondent à la surface de la première zone active 1 et de la zone d'isolation 5. Dans le premier matériau semi-conducteur 1, la zone vide correspond uniquement à la zone d'isolation 5.

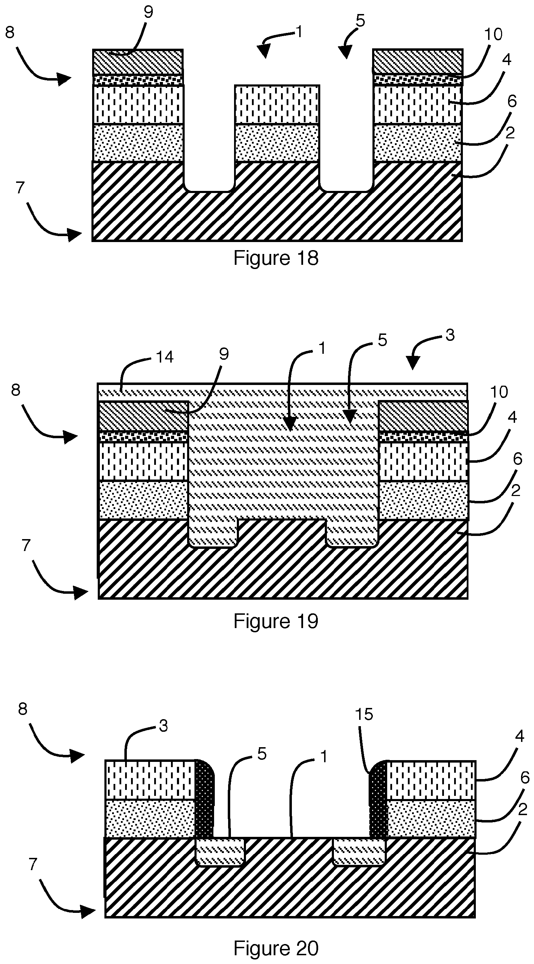

Comme illustré à la figure 19, dans tous les modes de réalisation, un premier matériau d'isolation 14 est déposé afin de remplir les zones vides du substrat souche et le masque de gravure 8. Ce premier matériau d'isolation 14 est un matériau isolant électriquement, par exemple de l'oxyde de silicium ou du nitrure de silicium. Le premier matériau d'isolation 14 peut être différent du second matériau d'isolation constituant la couche d'isolation 6. Les premier et second matériaux d'isolation peuvent également être identiques.

Le premier matériau d'isolation 14 rebouche la zone d'isolation formée dans le premier matériau semi-conducteur 2, mais également la zone vide représentative de la zone d'isolation 5 et de la première zone active 1 dans la couche d'isolation 6 et dans le second matériau semi-conducteur 4. Le premier matériau d'isolation 14 se dépose également sur le masque de gravure 8.

Le premier matériau d'isolation 14 subit de préférence une étape d'aplanissement, cette étape peut s'arrêter au-dessus ou au niveau du masque de gravure 8. Lors de cette opération, le masque de gravure peut être également gravé, mais il faut éviter de détériorer la surface principale du second matériau semi-conducteur 4. Une fois le premier matériau d'isolation 14 aplani, il subit une étape de gravure isotrope ou anisotrope afin de le localiser au niveau de la zone d'isolation 5 dans le premier matériau semi-conducteur 2. Dans cette étape de gravure, la planéité du premier matériau d'isolation est conservée tout au long de la gravure. Si la couche d'isolation 6 ou une autre des couches présentes et accessibles est réactive au procédé de gravure du premier matériau d'isolation 14, la gravure est réalisée au moyen d'un procédé anisotrope.

De cette manière, il est possible de positionner la surface supérieure du premier matériau d'isolation 14 où l'on veut par rapport à la surface principale de la première zone active 1 et/ou de la seconde zone active 2.

Dans un mode de réalisation avantageux illustré à la figure 20, la gravure du premier matériau d'isolation 14 est réalisée jusqu'à libérer la surface principale de la première zone active 1. Dans ce cas de figure, la surface principale de la première zone active 1 est exactement au même niveau que la surface principale de la zone d'isolation 5 en premier matériau d'isolation 14. La première zone active 1 et la zone d'isolation 5 ayant des formes complémentaires, aucune impureté ne peut se déposer à l'interface entre ces deux zones et les impuretés ne sont pas coincés sur la première zone active 1, par exemple à cause de zones d'isolation 5 qui sont plus hautes que la surface principale de la première zone active 1. De plus, le transistor formé sur la première zone active 1 ne présente pas de transistor parasite car la surface principale de la première zone active 1 n'est pas au-dessus de la surface de la zone d'isolation 5.

Il est également possible, de volontairement rabaisser la surface principale de la zone d'isolation par rapport à celle de la première zone active 1. Dans ce cas, le premier matériau d'isolation 14 présentant une surface plane, cette surface plane est répercutée tout au long de la gravure, même en dessus de la surface principale de la première zone active 1, c'est-à-dire après la libération de la surface principale de la première zone active 1.

Dans une variante de réalisation illustrée à la figure 20, un espaceur latéral 15 est formé sur le bord latéral de la seconde zone active 3 en second matériau semi-conducteur 4, au-dessus de la zone d'isolation 5 en premier matériau d'isolation 14. L'espaceur latéral 15 peut être formé après la localisation du premier matériau d'isolation 14 dans la zone d'isolation 5 du premier matériau semi-conducteur 2.

Un matériau isolant additionnel est déposé de manière conforme sur le substrat. Le matériau isolant additionnel recouvre le masque de gravure 8, la première zone active 1, le premier matériau d'isolation 14 et les parois latérales du masque de gravure 8, du second matériau semi-conducteur 4 et de la couche d'isolation 6. Le matériau isolant additionnel est ensuite gravé par plasma de manière anisotrope afin de ne localiser uniquement sur les parois latérales et ainsi former l'espaceur latéral 15.

L'espaceur latéral peut également être formé au cours de la gravure du premier matériau d'isolation 14. Le matériau isolant additionnel est déposé de manière conforme sur le substrat. Le matériau isolant additionnel recouvre le masque de gravure 8, le premier matériau d'isolation 14 et les parois latérales découvertes. Le matériau isolant additionnel est ensuite gravé par plasma de manière anisotrope afin de ne le localiser uniquement que sur les parois latérales. La gravure du premier matériau d'isolation 14 est alors reprise avec un procédé de gravure anisotrope et l'espaceur latéral est formé par le matériau isolant additionnel dans une partie supérieure et par le premier matériau d'isolation dans une partie inférieure.

L'épaisseur déposée du matériau isolant additionnel ainsi que l'épaisseur gravée dépendent de l'épaisseur choisie pour l'espaceur latéral.

Dans encore une autre variante de réalisation (non représentée), il est envisageable de ne libérer qu'une portion de la première zone active 1. Si l'espaceur latéral 15 est formé avant la libération de la surface principale de la première zone active 1 et si l'épaisseur de l'espaceur latéral 15 est supérieure à la distance séparant la première 1 et la seconde 3 zones actives (la largeur de la zone d'isolation 5), l'espaceur latéral 15 est disposé au-dessus de la première zone active 1. Il est alors possible d'utiliser l'espaceur latéral 15 comme masque de gravure et de ne libérer qu'une partie de la première zone active 1. Ce mode de réalisation est particulièrement avantageux si on souhaite réaliser une élévation de la hauteur de la face principale de la première zone active 1, par exemple, par épitaxie sélective. Il est à noter que ce mode de réalisation est difficile à mettre en oeuvre car il nécessite un certain nombre de contraintes géométriques pour obtenir un espaceur latéral 15 qui empiète sur la première zone active 1 (typiquement un masque de gravure très épais). L'ouverture dans le premier matériau d'isolation peut également être réalisée au moyen d'une étape de photolithographie additionnelle mais il y a alors perte de l'autoalignement de la première zone active 1 par rapport à la seconde zone active 3 et à la zone d'isolation 5.

Le masque de gravure 8 est ensuite éliminé, par toute technique adaptée, par exemple au moyen d'une gravure anisotrope telle qu'une gravure par voie humide et la surface principale de la seconde zone active est libérée.

Ce procédé de réalisation est particulièrement intéressant car il permet de manière autoalignée de former des première 1 et seconde 3 zones actives et une zone d'isolation 5. La position, la forme et les dimensions des différentes zones sont définies dès le masque de gravure 8.

Il est ainsi possible d'obtenir un substrat hybride qui comporte une première zone active 1 en premier matériau semi-conducteur 2, une seconde zone active 3 en second matériau semi-conducteur 4, les première 1 et seconde 2 zones actives étant disposées, latéralement, de part et d'autre d'une zone d'isolation 5 en premier matériau d'isolation 14. Les premier 2 et second 4 matériaux semi-conducteurs sont séparés par une couche d'isolation 6 en second matériau d'isolation dans une direction perpendiculaire à une surface principale d'une couche de support 7. Par ailleurs, la zone d'isolation 5 comporte une surface principale qui forme un plan unique avec la surface principale de la première zone active 1. La zone d'isolation 5 et la première zone active 1 ont des formes complémentaires le long de l'interface entre la zone d'isolation 5 et la première zone active 1. Les secondes zones actives 3 sont séparées électriquement des premières zones actives 1 par la couche d'isolation 6, d'un point de vue vertical.

Ce substrat hybride est particulièrement avantageux car il autorise la formation de dispositifs spécifiques sur des zones actives présentant des caractéristiques électroniques et/ou cristallograhiques prédéfinies. Les zones actives présentent une excellente qualité de surface car elles ont toujours été protégées des étapes agressives. Les surfaces principales des zones actives sont, en générale, libérées au moyen d'une gravure humide. Le substrat ne présente pas des topographies de surface à proximité immédiate des zones actives surtout au niveau de la première zone active. Ceci a pour effet de limiter les risques de contamination lié à un problème de nettoyage et de limiter les transistors parasites. Les topographies existantes sont déportées au-dessus des zones d'isolation ce qui limite l'effet de matériaux parasites sur le fonctionnement du dispositif.

## Revendications

1. Substrat hybride comportant :
- un empilement comportant successivement, selon une première direction, une couche de support (7), une couche en premier matériau semi-conducteur (2), une couche d'isolation (6) en second matériau d'isolation et une couche en second matériau semi-conducteur (4),
- une première zone active (1) définie dans la couche en premier matériau semi-conducteur (2),
- une seconde zone active (3) définie dans la couche en second matériau semi-conducteur (4),
- une zone d'isolation (5) en premier matériau d'isolation (14) formée dans la couche en premier matériau semi-conducteur (2), la zone d'isolation (5) entourant la première zone active (1) et séparant la première zone active (1) et la deuxième zone active (3) dans une direction d'observation selon la première direction,
substrat hybride **caractérisé en ce que** la zone d'isolation (5) comporte une première portion bordant au moins un bord latéral de la première zone active (1), la première portion et la première zone active (1) ayant une face principale libérée en éliminant le second matériau semi-conducteur (4) et la couche d'isolation (6) se trouvant juste au-dessus de la première zone active (1), la face principale libérée formant un même plan avec l'interface entre la couche en premier matériau semi-conducteur (2) et la couche d'isolation (6), la zone d'isolation (5) et la première zone active (1) ayant des formes complémentaires le long d'une interface entre la zone d'isolation (5) et la première zone active (1).

2. Substrat hybride selon la revendication 1 dans lequel la couche en premier matériau semi-conducteur (2) présente une orientation identique à l'orientation du second matériau semi-conducteur (4).

3. Substrat hybride selon la revendication 1 dans lequel la couche en premier matériau semi-conducteur (2) présente une orientation différente de l'orientation du second matériau semi-conducteur (4).

4. Substrat hybride selon l'une des revendications 1 à 3 dans lequel le premier matériau semi-conducteur (2) est identique au second matériau semi-conducteur (4).

5. Substrat hybride selon l'une des revendications 1 à 3 dans lequel le premier matériau semi-conducteur (2) est différent du second matériau semi-conducteur (4).

6. Substrat hybride selon l'une des revendications 1 à 5 dans lequel le premier matériau d'isolation (14) est différent du second matériau d'isolation.

7. Substrat hybride selon l'une des revendications 1 à 5 dans lequel le premier matériau d'isolation (14) est identique au second matériau d'isolation la couche d'isolation 6.

8. Substrat hybride selon l'une des revendications 1 à 7 comportant un espaceur latéral (15) sur un bord latéral de la seconde zones active (3) en second matériau semiconducteur (4), au-dessus de la zone d'isolation (5) en premier matériau d'isolation (14).
